# DEMANDE DE BREVET EUROPEEN

(11) **EP 4 521 884 A1**
(43) Date de publication de la demande: **12.03.2025**
(21) Numéro de dépôt: 24198348.5
(22) Date de dépôt: 04.09.2024
(51) Int. Cl.: H10D 64/27, H01L 23/48, H01L 23/482, H10D 30/47, H10D 30/60, H10D 64/23, H10D 62/17, H10D 62/85

(54) **DISPOSITIF ÉLECTRONIQUE**

(30) Priorité: 07.09.2023 FR 2309400
(71) Demandeur: STMicroelectronics International N.V., 1228 Plan-les-Ouates, Geneva (CH)
(72) Inventeur: OHEIX, Thomas, 38100 GRENOBLE (FR); NONGAILLARD, Matthieu, 38000 GRENOBLE (FR)
(74) Mandataire: Cabinet Beaumont

(57) **Abrégé**

La présente description concerne un dispositif comprenant des tranchées (44), les tranchées (44) comprenant chacune un élément conducteur configuré pour relier électriquement les doigts (35) de grilles de transistors (26), situés du côté d'une première face d'une première couche, à une deuxième couche s'étendant du côté d'une deuxième face de la première couche.

## Description

### Domaine technique

La présente description concerne de façon générale les dispositifs électroniques et plus particulièrement les dispositifs électroniques comprenant des transistors.

### Technique antérieure

De nombreux dispositifs électroniques comprennent des transistors et plus particulièrement des transistors à grille commune. Par transistors à grille commune, on entend des transistors dont les grilles sont reliées, de préférence connectées, ensemble, de telle manière que les transistors soient commandés par la même tension de commande. Par exemple, de tels transistors peuvent être des transistors élémentaires, c'est-à-dire des transistors de petite taille, ayant tous les mêmes dimensions, reliés ensembles de manière à former l'équivalent d'un transistor de dimensions supérieures. Ainsi, les grilles des transistors élémentaires sont reliées, de préférence connectées, ensembles, les drains des transistors élémentaires sont reliés, de préférence connectés, ensembles, et les sources des transistors élémentaires sont reliées, de préférence connectées, ensembles.

Il existe ainsi un besoin de s'assurer que les transistors reçoivent la même tension de commande et reçoivent ladite tension de commande simultanément.

### Résumé de l'invention

Un mode de réalisation prévoit un dispositif comprenant des tranchées, les tranchées comprenant chacune un élément conducteur configuré pour relier électriquement les doigts de grilles de transistors, situés du côté d'une première face d'une première couche, à une deuxième couche s'étendant du côté d'une deuxième face de la première couche.

Un autre mode de réalisation prévoit un procédé de fabrication d'un dispositif comprenant la formation de tranchées, les tranchées comprenant chacune un élément conducteur configuré pour relier électriquement les doigts de grilles de transistors, situés du côté d'une première face d'une première couche, à une deuxième couche s'étendant du côté d'une deuxième face de la première couche.

Selon un mode de réalisation, la deuxième couche est configurée pour être polarisée à la tension de commande des transistors.

Selon un mode de réalisation, les transistors sont agencés en lignes, les transistors d'une même ligne étant reliés ensemble par leur grille par un même doigt, les lignes étant agencées en colonnes, les colonnes étant séparées deux à deux par une tranchée, l'élément conducteur de chaque tranchée séparant deux colonnes étant relié à une extrémité de chacun des doigts des deux colonnes.

Selon un mode de réalisation, chaque colonne est située entre deux tranchées parmi lesdites tranchées, chaque doigt étant relié, par une extrémité, à l'élément conducteur d'une des deux tranchées, et, par une autre extrémité, à l'élément conducteur de l'autre des deux tranchées.

Selon un mode de réalisation, la première couche est en GaN, en AlN ou en AlGaN. Selon un mode de réalisation, la première couche comporte du GaN, de l'AlN et de l'AlGaN.

Selon un mode de réalisation, le dispositif comprend un substrat semiconducteur du côté de la deuxième face de la première couche, le substrat constituant la deuxième couche.

Selon un mode de réalisation, chaque tranchée comprend une cavité traversant la première couche, le fond de la cavité étant formé par le substrat, et l'élément conducteur comprenant une troisième couche conductrice s'étendant sur les parois et le fond de la cavité.

Selon un mode de réalisation, le dispositif comprend un substrat semiconducteur du côté de la deuxième face de la première couche, la face du substrat la plus éloigné de la première couche étant recouverte d'une quatrième couche conductrice, la quatrième couche constituant la deuxième couche.

Selon un mode de réalisation, la troisième couche est en métal.

Selon un mode de réalisation, chaque tranchée comprend une cavité traversant la première couche, le fond de la cavité étant situé au niveau de la face du substrat la plus proche de la première couche, l'élément conducteur comprenant une troisième couche conductrice s'étendant sur les parois et le fond de la cavité et une partie située dans le substrat, en contact avec la troisième couche et en contact avec la quatrième couche.

Selon un mode de réalisation, la troisième couche est séparée de la première couche par une cinquième couche isolante.

Selon un mode de réalisation, le substrat est en silicium ou en silicium carboné.

Selon un mode de réalisation, chaque élément conducteur est relié aux doigts par des pistes et des vias d'un réseau d'interconnexion.

Un autre mode de réalisation prévoit un procédé de fabrication d'un dispositif électronique comprenant la formation de tranchées, les tranchées comprenant chacune un élément conducteur configuré pour relier électriquement des doigts de grilles de transistors, situés du côté d'une première face d'une première couche, à une deuxième couche s'étendant du côté d'une deuxième face de la première couche, dans lequel les transistors sont agencés en lignes, les transistors d'une même ligne étant reliés ensemble par leur grille par un même doigt, les lignes étant agencées en colonnes, les colonnes étant séparées deux à deux par une tranchée, l'élément conducteur de chaque tranchée séparant deux colonnes étant relié à une extrémité de chacun des doigts des deux colonnes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un exemple de transistor ;
la figure 2 représente schématiquement un exemple d'un dispositif électronique ;
la figure 3 représente schématiquement un mode de réalisation d'un dispositif électronique ;
la figure 4 représente plus en détail une partie d'un mode de réalisation d'un dispositif électronique ;
la figure 5 représente plus en détail une autre partie du mode de réalisation de la figure 4 ;
la figure 6 représente plus en détail une partie d'un autre mode de réalisation d'un dispositif électronique ; et
la figure 7 représente plus en détail une autre partie du mode de réalisation de la figure 6.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

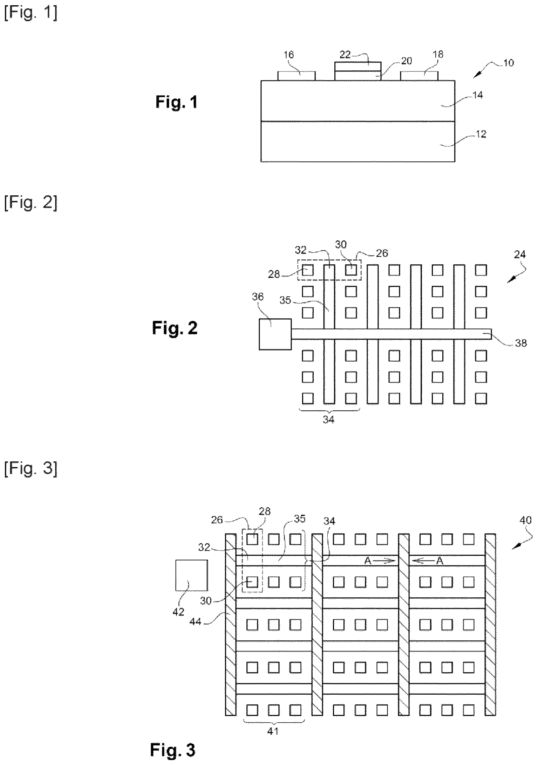

La figure 1 représente schématiquement un exemple de transistor 10 d'un dispositif électronique. Le dispositif électronique comprend par exemple une puce dans laquelle est formé le transistor.

Le transistor 10 est un transistor à base de nitrure de galium (GaN). Le transistor 10 est de préférence un transistor à effet de champ à grille isolée (MOSFET ou Métal Oxide Semiconductor Field Effect Transistor). Le transistor 10 peut alternativement être un transistor à grille Schottky.

Le dispositif comprend un substrat 12. Le transistor 10 est formé sur le substrat 12. Le substrat 12 est en un matériau semiconducteur, par exemple en silicium.

Le dispositif comprend une couche 14, en nitrure de gallium. La couche 14 repose sur, et est de préférence en contact avec, une face supérieure du substrat 12. La couche 14 est par exemple formée par épitaxie à partir du substrat 12. La couche 14 peut alternativement correspondre à un empilement de couches comprenant une couche de GaN et des couches d'AlN et de AlGaN.

La couche 14 comprend par exemple les régions de source et de drain du transistor 10. Les différentes régions du transistor 10 ne sont pas représentées en figure 1.

Le dispositif comprend un élément de contact 16, par exemple en métal, reposant sur, et de préférence en contact avec, la région de source du transistor 10. L'élément 16 repose par exemple sur, par exemple en contact avec, la couche 14, plus précisément avec la région de source située dans la couche 14. L'élément 16 repose de préférence sur, de préférence en contact avec, la face supérieure de la couche 14.

Similairement, le dispositif comprend un élément de contact 18, par exemple en métal, reposant sur, et de préférence en contact avec, la région de drain du transistor 10. L'élément 18 repose par exemple sur, par exemple en contact avec, la couche 14, plus précisément avec la région de drain située dans la couche 14. L'élément 18 repose de préférence sur, de préférence en contact avec, la face supérieure de la couche 14.

Le transistor 10 comprend en outre une région de grille 20. La région 20 est de préférence en un matériau semiconducteur, par exemple en nitrure de galium, pour une grille Schottky, ou en un matériau isolant, par exemple en SiO2, en SiN ou en Al2O3, pour une grille isolé. La région 20 repose de préférence sur, et est en contact avec, la face supérieure de la couche 14. La région de grille est par exemple située entre les éléments 16 et 18.

Le dispositif comprend en outre un élément de contact 22, par exemple en métal, reposant sur, et de préférence en contact avec, la région de grille 20 du transistor 10.

La face inférieure du substrat 12, c'est-à-dire la face opposée de la face supérieure, est par exemple recouverte par, de préférence en contact avec, une couche conductrice non représentée, par exemple une couche métallique.

Le dispositif comprend en outre un réseau d'interconnexion non représenté. Autrement dit, le dispositif comprend des couches isolantes non représentées recouvrant la face supérieure du dispositif, et donc recouvrant la face supérieure de la couche 14, la région 20 et les éléments 16, 18, 22. Lesdites couches non représentées comprennent des pistes conductrices et des vias conducteurs, non représentés, permettant d'assurer des connexions entre les éléments du dispositif ou entre le dispositif et un dispositif externe.

La figure 2 représente schématiquement un exemple d'un dispositif électronique 24. Plus précisément, la figure 2 représente, schématiquement, une vue de dessus d'un ensemble de transistors 26. La figure 2 représente un exemple d'agencement de transistors dans un dispositif électronique 24, et plus précisément illustre les connexions des grilles de transistors.

Le dispositif 24 comprend une pluralité de transistors 26. Les transistors 26 correspondent par exemple à des transistors tels que le transistor 10 de la figure 1. Cependant, les transistors 26 peuvent être d'un autre type de transistors à base de nitrure de gallium, c'est-à-dire d'un autre type de transistors dont les régions de drain et de source sont situées dans une couche en nitrure de gallium. Ainsi, le transistor 26 est par exemple un transistor MOSFET ou un transistor à grille p-GaN, c'est-à-dire un transistor à grille Schottky.

Les transistors 26 sont par exemple des transistors élémentaires. Les transistors 26 sont par exemple tous identiques. Les transistors 26 ont une grille commune. Autrement dit, les grilles de tous les transistors 26 sont reliées, de préférence connectées, entre elles. Les drains de tous les transistors sont par exemple reliés, de préférence connectés, entre eux. Les sources de tous les transistors sont par exemple reliées, de préférence connectées, entre elles.

En figure 2, chaque transistor 26 est représenté par un élément de contact de source 28, un élément de contact de drain 30 et un élément de contact de grille 32. Les éléments 28 et 30 correspondent par exemple respectivement à l'élément 16 de la figure 1 et à l'élément 18 de la figure 1. L'élément 32 correspond par exemple à l'élément 22 de la figure 1.

Les transistors 26 du dispositif sont agencés en lignes 34. Plus précisément, les transistors 26 d'une ligne 34 sont agencés de telles manière que les plots 28 et 30 forment respectivement des lignes parallèles. Les différentes lignes 34 sont agencées de manière à être parallèles les unes aux autres.

Les éléments de contact 32 des transistors 26 d'une même ligne 34 sont constitués par des portions d'une même piste conductrice 35, autrement dit du même doigt 35. Autrement dit, le dispositif comprend, pour chaque ligne 34, une piste conductrice 35, correspondant par exemple à une piste conductrice du réseau d'interconnexion du dispositif. La piste 35 s'étend en regard de chaque transistor et est reliée, de préférence connectée, aux régions de grille de chaque transistor 26 de la ligne 34 correspondant. Les transistors d'une même ligne 34 sont ainsi reliés, de préférence connectés, ensembles par la grille.

Dans l'exemple de la figure 2, le dispositif 24 comprend un plot 36 d'application de la tension de commande, c'est-à-dire la tension fournie à toutes les grilles des transistors 26. Ainsi, le plot 36 reçoit la tension de commande d'une source de tension non représentée.

Le dispositif 24 comprend en outre une piste conductrice 38. La piste 38 est reliée, de préférence connectée, au plot 36. Par exemple, la piste 38 est une piste conductrice, ou métallisation, du réseau d'interconnexion du dispositif. Ainsi, la piste 38 est par exemple reliée au plot 36 par des vias conducteur. La piste 38 est ainsi polarisée par la tension de commande.

La piste 38 s'étend dans une première direction. Les doigts s'étendent dans une autre direction, par exemple une direction perpendiculaire à la direction de la piste 38 dans le plan de la figure 2. Les lignes 34 de transistors 26 s'étendent dans la deuxième direction.

La piste 38 est reliée, de préférence connectée, à toutes les pistes 35, de manière à fournir la tension de commande à l'ensemble des transistors 26.

Lors du fonctionnement du dispositif, la polarisation des grilles des transistors 26 est fournie par le plot 36 et les pistes 35 et 38. Cependant, dans les dispositifs possédant un grand nombre de transistors et un grand nombre de doigt, il existe un délai important entre le moment d'application de la tension de commande sur le plot 36, et ainsi sur l'extrémité de la piste 38 proche du plot 36 et le moment ou l'autre extrémité de la piste 38 est polarisée. Un tel délai, causé par la résistivité de la piste 38, peut être problématique, particulièrement lors de pics de courant qui peuvent alors être concentrés sur un nombre faible de lignes 34 au lieu d'être réparti sur l'ensemble des transistors.

La figure 3 représente schématiquement un mode de réalisation d'un dispositif électronique 40. Plus précisément, la figure 3 représente, schématiquement, une vue de dessus d'un ensemble de transistors 26. La figure 3 représente un exemple d'agencement de transistors dans un dispositif électronique, et plus précisément illustre les connexions des grilles de transistors.

Comme le dispositif 24 de la figure 2, le dispositif 40 comprend une pluralité de transistors 26. Les transistors 26 correspondent par exemple à des transistors tels que le transistor 10 de la figure 1. Cependant, les transistors 26 peuvent être d'un autre type de transistors à base de nitrure de gallium ou un type de transistor à base d'AlGaN ou de nitrure d'aluminium (AlN), c'est-à-dire d'un autre type de transistors dont les régions de drain et de source sont situées dans une couche en nitrure de gallium.

Comme en figure 2, les transistors 26 sont par exemple des transistors élémentaires. Les transistors 26 sont par exemple tous identiques. Les transistors 26 ont une grille commune. Autrement dit, les grilles de tous les transistors 26 sont reliées, de préférence connectées, entre elles.

En figure 3, comme en figure 2, chaque transistor 26 est représenté par un élément de contact de source 28, un élément de contact de drain 30 et un élément de contact de grille 32. Les éléments 28 et 30 correspondent par exemple respectivement à l'élément 16 de la figure 1 et à l'élément 18 de la figure 1. L'élément 32 correspond par exemple à l'élément 22 de la figure 1.

Le dispositif 40 comprend, comme le dispositif 24 de la figure 2, des lignes 34 de transistors 26. Comme en figure 2, les transistors 26 d'une ligne 34 sont agencés de telles manière que les plots 28 et 30 forment respectivement des lignes parallèles. Les différentes lignes 34 sont agencées de manière à être parallèles les unes aux autres.

Les éléments de contact des transistors 26 d'une même ligne 34 sont constitués par des portions d'une même piste conductrice 35, autrement dit du même doigt 35. Autrement dit, le dispositif comprend, pour chaque ligne 34, une piste conductrice 35, correspondant par exemple à une piste conductrice du réseau d'interconnexion du dispositif. La piste 35 s'étend en regard de chaque transistor et est reliée, de préférence connectée, aux régions de grille de chaque transistor 26 de la ligne 34 correspondant. Les transistors d'une même ligne 34 sont ainsi reliés, de préférence connectés, ensembles par la grille.

Dans l'exemple de la figure 3, chaque ligne 34 comprend trois transistors de manière à clarifier la représentation. Les lignes peuvent comprendre un nombre quelconque de transistors 26, par exemple au moins dix transistors. Les drains de tous les transistors d'une ligne sont par exemple reliés, de préférence connectés, entre eux. Les sources de tous les transistors d'une ligne sont par exemple reliées, de préférence connectées, entre elles.

Dans l'exemple de la figure 3, les lignes 34 de transistors sont agencées en colonnes 41. Les colonnes 41 s'étendent par exemple dans une direction perpendiculaire à la direction dans laquelle s'étend la ligne. Ainsi, les pistes 35 des lignes d'une même colonnes 41 sont parallèles entre elles et sont séparées les unes des autres par les lignes d'éléments 28 ou les lignes d'éléments 30. Les colonnes 41 sont parallèles les unes aux autres. Le dispositif comprend au moins une colonne, par exemple au moins trois colonnes.

Dans l'exemple de la figure 3, le dispositif 40 comprend un plot 42 d'application de la tension de commande, c'est-à-dire la tension fournie à toutes les grilles des transistors 26. Ainsi, le plot 42 reçoit la tension de commande d'une source de tension non représentée. Le plot 42 est de préférence situés en dehors de la région dans laquelle sont situés les transistors 26. De manière plus générale, le dispositif peut comprendre plusieurs plots 42, par exemple situés à différents endroits autour des transistors 26.

Le dispositif comprend une couche conductrice ou semiconductrice, non représentée en figure 3, s'étendant du côté inférieur de la couche de nitrure de galium dans laquelle sont situées les régions de source et de drain. Ainsi, la région de grille, c'est-à-dire la région 20 dans l'exemple de la figure 1, est de préférence séparée de ladite couche conductrice ou semiconductrice par ladite couche en nitrure de gallium. La piste 35 est de même de préférence séparée de ladite couche conductrice ou semiconductrice par ladite couche en nitrure de gallium.

La couche conductrice ou semiconductrice non représentée s'étend de préférence en regard de l'ensemble de la région du dispositif dans laquelle sont situés les transistors. Ainsi, tous les transistors sont situés en regard de ladite couche.

La couche conductrice ou semiconductrice non représentée est polarisé à la tension de commande. La couche conductrice ou semiconductrice est par exemple reliée, de préférence connectée, au plot 42, plus précisément à une extrémité inférieure du plot 42. Ainsi, le plot 42 s'étend de préférence du côté supérieur de la puce dans laquelle sont formées les transistors au côté inférieur de la puce. L'extrémité supérieure du plot 42 est par exemple reliée, de préférence connectée, au réseau d'interconnexion de manière à recevoir la tension de commande. L'extrémité inférieure du plot 42 est reliée, de préférence connectée, à la couche conductrice ou semiconductrice, qui est ainsi polarisée à la tension de commande.

Selon un autre mode de réalisation, le dispositif 40 ne comprend pas de plot 42. La couche conductrice ou semiconductrice non représentée est alors reliée à la source de la tension de commande sans traverser le substrat 12, par exemple par contact avec un autre dispositif. La couche conductrice ou semiconductrice non représentée est par exemple reliée à la source de la tension de commande au travers de la couche 54 via la cavité 56.

Le dispositif 40 comprend des tranchées 44. Chaque colonne 41 est séparée de la colonne 41 voisine par une tranchée 44. De préférence, chaque colonne est située entre deux tranchées 44. Chaque tranchée 44 s'étend de préférence le long de tous les ensembles 34 de transistors 26. Autrement dit, chaque tranchée 44 s'étend de la piste 35 du premier ensemble 34 de la colonne à la piste 35 du dernier ensemble 34 de la colonne.

Chaque tranchée 44 traverse au moins la couche en nitrure de galium dans laquelle les régions de source et de drain sont situées. Chaque tranchée 44 atteint la couche conductrice ou semiconductrice.

Chaque tranchée 44 comprend un élément conducteur s'étendant jusqu'à la couche semiconductrice ou conductrice et étant relié, directement ou par des pistes conductrices et des vias conducteurs du réseau d'interconnexion, aux pistes 35 des ensembles 34 des colonnes 41 situées de part et d'autre de la tranchée 44. Ainsi, au moins une extrémité de chaque piste 34 est reliée, de préférence connectée, à la couche conductrice ou semiconductrice par un élément conducteur d'une tranchée 44.

De préférence, chaque colonne est située entre deux tranchées 44. Ainsi, les deux extrémités de chaque piste 35 sont de préférence reliées, de préférence connectées, à la couche conductrice ou semiconductrice par des éléments conducteurs des tranchées 44 situées de part et d'autre de la colonne 41.

L'élément conducteur de chaque tranchée 44 est isolé électriquement de la couche de nitrure de galium.

La polarisation de la couche conductrice ou semiconductrice est de préférence effectuée par plusieurs plots 42. Ainsi, l'ensemble de ladite couche est polarisé à la tension de commande. L'ensemble des transistors 26 est ainsi plus proche d'une tranchée 44, fournissant la tension de commande que les transistors 26 de la figure 2 ne sont du plot 36. Bien qu'il puisse exister un court délai entre les transistors d'une même ligne 34, ce délai est bien inférieur au délai de la figure 2. De plus, les transistors 26 situés aux mêmes emplacements sur différentes lignes sont à même distance de la couche conductrice ou semiconductrice.

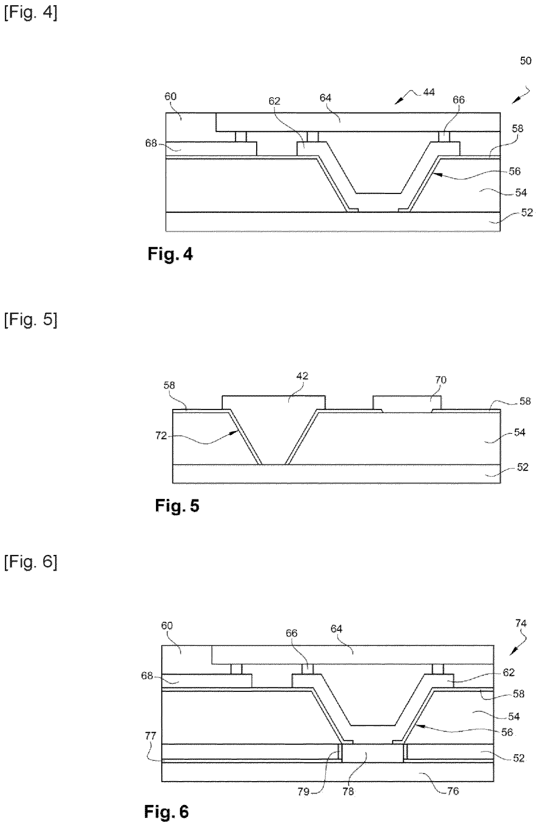

La figure 4 représente plus en détail une partie d'un mode de réalisation d'un dispositif électronique 50. Plus précisément, la figure 4 représente une vue en coupe d'une tranchée 44 telle que décrite en figure 3, par exemple selon un plan A-A de la figure 3, située dans une puce du dispositif 50.

Le dispositif 50, et plus précisément la puce, comprend un substrat 52. Le substrat 52 correspond par exemple au substrat 12 de la figure 1. Le substrat 12 est de préférence en un matériau semiconducteur, par exemple en silicium ou en silicium carboné. Le substrat 52 est en un matériau différent de la couche 54.

Le dispositif 50 comprend par exemple une couche conductrice non représentée s'étendant sur une face inférieure du substrat 52.

Le dispositif 50 comprend une couche 54 en nitrure de gallium. La couche 54 a par exemple une épaisseur supérieure à 4 µm. La couche 54 correspond par exemple à la couche 14 de la figure 1. Ainsi, les régions de source et de drain des transistors 26 de la figure 3 sont situées de préférence dans la couche 54. La couche 54 s'étend sur une face supérieure du substrat 52. La couche 54 est par exemple en contact avec le substrat 52.

La couche 54 comprend une cavité 56 s'étendant au moins d'une face supérieure de la couche 54 à une face inférieure de la couche 54. La cavité 56 atteint la face supérieure du substrat 52. Le fond de la cavité 56 est ainsi constitué d'une portion de la face supérieure du substrat 52.

Le dispositif 50 comprend une couche isolante 58. La couche 58 recouvre les parois latérales de la cavité 56. La couche 58 recouvre par exemple une partie périphérique de la portion du substrat 52 constituant le fond de la cavité. Une partie centrale de la portion du substrat 52 constituant le fond de la cavité n'est pas recouverte par la couche 58. La couche 58 recouvre par exemple au moins partiellement la face supérieure de la couche 54, par exemple au moins la portion de la face supérieure de la couche 54 entourant la cavité 56.

Le dispositif 50 comprend un réseau d'interconnexion. Autrement dit, le dispositif 50 comprend un empilement 60 de couches isolantes recouvrant la face supérieure de la puce. Les couches isolantes de l'empilement 60 comprennent des pistes conductrices et des vias conducteurs permettant d'assurer des connexions entre les éléments du dispositif 50 ou entre le dispositif 50 et un dispositif externe.

Le dispositif 50 comprend un élément conducteur 62, par exemple en métal. L'élément conducteur 62 correspond par exemple à un niveau de métallisation M0 d'un réseau d'interconnexion, c'est-à-dire correspond par exemple au niveau de pistes conductrices le plus proche de la couche 54.

L'élément 62 s'étend au moins sur toute la hauteur de la tranchée 56. Plus précisément, l'élément 62 atteint le fond de la cavité 56 et est en contact avec le substrat 52 par la partie centrale de la portion du substrat 52 constituant le fond de la cavité. L'élément 62 s'étend sur les parois de la cavité, et plus précisément, sur la couche 58 recouvrant les parois de la cavité. En outre, l'élément 62 s'étend par exemple sur une portion de la face supérieure de la couche 54 autour de la cavité 56, plus précisément sur la couche 58 recouvrant une portion de la face supérieure de la couche 54 autour de la cavité 56, de préférence de part et d'autre de la tranchée 44. L'élément 62 n'est de préférence pas en contact avec la couche 54. De préférence, l'élément 62 est entièrement séparé de la couche 54 par la couche isolante 58.

Dans l'exemple de la figure 4, l'élément 62 ne remplit pas la cavité 56, l'élément 62 étant recouvert, dans la cavité 56, par un matériau isolant. Alternativement, l'élément 62 peut remplir la cavité 56 au-dessus de la couche 58.

Le dispositif 50 comprend en outre une piste 64. La piste 64 est par exemple située dans un niveau de métallisation supérieur au niveau de l'élément 62, par exemple le niveau M1. La piste 64 s'étend de préférence sur toute la longueur de la tranchée 44. De préférence, toute la tranchée 44 est ainsi recouverte par la piste 64. L'élément 62 et la piste 64 sont reliés par des vias 66. Par exemple, l'élément 62 et la piste 64 sont reliés par des vias situés de part et d'autre de la tranchée, par exemple, par sensiblement autant de vias 66 sur un côté de la tranchée que sur l'autre côté de la tranchée.

En figure 4, le dispositif 50 comprend par exemple une piste conductrice 68. La piste 68 correspond par exemple à un doigt 35 de la figure 3. La piste 38 est par exemple située dans le niveau de métallisation M0. La piste 68 s'étend par exemple sur, et par exemple en contact avec, la couche 58.

Dans l'exemple de la figure 4, une seule piste 68 est représentée. En pratique, il y a autant de pistes 68 que de doigts 35, c'est-à-dire autant que de lignes 34. Pour les tranchées 44 situées entre deux lignes 34, la piste 64 est reliée, par des vias 66, aux doigts 35 de part et d'autre de la tranchée.

A titre de variante, l'élément 62 peut ne pas être relié à la piste 68 par la piste 64 et les vias 66. La piste 68 peut être une continuation de l'élément 62 et donc être en contact avec l'élément 62.

Le procédé de fabrication du dispositif 50 comprend par exemple :
- la formation du substrat 52 ;
- la formation, éventuelle, de la couche conductrice non représentée sur la face inférieure du substrat 52 ;
- la formation, par exemple par épitaxie, de la couche 54 ;
- la gravure de la couche 54 de manière à former la cavité 56 ;
- la formation de la couche 58 sur l'ensemble de la structure ;
- la gravure de la portion de la couche 58 située au centre du fond de la cavité 56 ;
- le dépôt de l'élément conducteur 62 ;
- un recuit de manière à former une connexion électrique entre l'élément 62 et le substrat 52 ; et
- la formation du réseau d'interconnexion.

La figure 5 représente plus en détail une autre partie du dispositif 50 du mode de réalisation de la figure 4. Plus précisément, la figure 5 représente un plot 42 de la figure 3 et un plot 70 d'application de la tension de drain. Le plot 70 n'est pas représenté en figure 3. Les plots 42 et 70 sont situés sur la même puce, et dans le même dispositif 50 que la structure de la figure 4. Ainsi, la structure de la figure 5 comprend des éléments de la figure 4. La structure de la figure 5 comprend ainsi le substrat 52, la couche 54, et la couche 58. La structure de la figure 5 comprend en outre le réseau d'interconnexion, non représenté. Autrement dit, la structure de la figure 5 comprend l'empilement 60 de couches isolantes, non représentée en figure 5, l'empilement comprenant des pistes conductrices et des vias conducteurs.

Le dispositif 50 comprend une cavité 72 dans la couche 54. La cavité 72 s'étend au moins d'une face supérieure de la couche 54 à une face inférieure de la couche 54. La cavité 72 atteint la face supérieure du substrat 52. Le fond de la cavité 72 est ainsi constitué d'une portion de la face supérieure du substrat 52.

La couche 58 recouvre les parois latérales de la cavité 72. La couche 58 recouvre par exemple une partie périphérique de la portion du substrat 52 constituant le fond de la cavité. Au moins une partie centrale de la portion du substrat 52 constituant le fond de la cavité 72 n'est pas recouverte par la couche 58. La couche 58 recouvre par exemple au moins partiellement la face supérieure de la couche 54, par exemple au moins la portion de la face supérieure de la couche 54 entourant la cavité 72.

Le dispositif 50 comprend, en figure 5, un plot 42, tel que décrit en relation avec la figure 3. Le plot 42 est de préférence en un matériau conducteur, par exemple en métal par exemple en le même matériau que l'élément 62 de la figure 4. Le plot 42 remplit, de préférence entièrement, la cavité 72. Le plot 42 recouvre de préférence les portions de la couche 58 situées dans la cavité 72. Le plot 42 est en contact avec le substrat 52, plus précisément avec la portion du substrat 52 formant le fond de la cavité 72. Le plot s'étend de préférence de la face supérieure du substrat 52 à au moins le niveau de l'ouverture de la cavité 72, de préférence jusqu'à un niveau supérieur à l'ouverture de la cavité 72. Ainsi, le plot 42 comprend une partie située à l'extérieur de la cavité 72.

Le plot 42 est relié, de préférence connecté, à une source de tension fournissant la tension de commande des transistors 26 des lignes 34 de la figure 3. Le plot 42 est par exemple relié, de préférence connecté, à ladite source de tension par le réseau d'interconnexion non représenté, plus précisément par des pistes conductrices et des vias conducteurs du réseau d'interconnexion non représenté.

Le dispositif 50 comprend en outre le plot 70. Le plot 70 est en un matériau conducteur, par exemple en métal, par exemple en le même matériau que le plot 42, par exemple en le même matériau que l'élément 62 de la figure 4. Le plot 70 traverse la couche 58 pour atteindre la couche 54. Le plot 70 est ainsi en contact avec la couche 54, de préférence avec la face supérieure de la couche 54.

Le plot 70 est relié, de préférence connecté, à une source de tension fournissant la tension de drain des transistors 26 des lignes 34 de la figure 3. Le plot 70 est par exemple relié, de préférence connecté, à ladite source de tension par le réseau d'interconnexion non représenté, plus précisément par des pistes conductrices et des vias conducteurs du réseau d'interconnexion non représenté.

Le dispositif 50 comprend par exemple plusieurs plots 42 tels que décrits en relation avec la figure 5. Les plots 42 sont de préférence situés autour de la pluralité de transistors 26 de la figure 3. Similairement, le dispositif 50 comprend par exemple plusieurs plots 70 tels que décrits en relation avec la figure 5. Les plots 70 sont de préférence situés autour de la pluralité de transistors 26 de la figure 3.

La figure 6 représente plus en détail une partie d'un autre mode de réalisation d'un dispositif électronique 74. Plus précisément, la figure 6 représente une vue en coupe d'une tranchée 44 telle que décrite en figure 3, par exemple selon un plan A-A de la figure 3, située dans une puce du dispositif 74.

Le dispositif 74 comprend des éléments identiques à des éléments du dispositif 50. Ces éléments ne seront pas de nouveau décrits en détails. Ainsi, le dispositif 74 comprend le substrat 52, la couche 54, la cavité 56, la couche isolante 58, l'élément conducteur 62 et le réseau d'interconnexion comprenant l'empilement 60 de couches isolantes, les pistes conductrices 64, 68 et les vias conducteurs 66.

Le dispositif 74 comprend en outre une couche conductrice 76, par exemple en métal, recouvrant la face inférieure du substrat 52. La couche 76 est par exemple en contact avec la face inférieure du substrat 52. La couche 76 s'étend au moins en regard de chaque tranchée 44.

Le dispositif 74 comprend en outre une couche 77. La couche 77 est une couche isolante. La couche 77 sépare la couche 76 et le substrat 52. La couche 77 est par exemple en contact, par sa face supérieure, au substrat 52 et, par sa face inférieure, à la couche 76. Ainsi, la couche 76 et le substrat 52 ne sont pas en contact.

Le dispositif 74 comprend, pour chaque tranchée 44, un élément conducteur 78, par exemple en métal, dans le substrat 52. L'élément 78 traverse le substrat 52 et la couche 77. L'élément 78 s'étend de la face supérieure du substrat 52 à la face inférieure de la couche 77. La face inférieure de l'élément 78 est en contact avec la couche 76. L'élément 78 est situé en regard de, et en contact avec, la tranchée 44 correspondante. Plus précisément, la face supérieure de l'élément 78 est au moins partiellement en contact avec l'élément 62. La face supérieure de l'élément 78 est par exemple en contact avec la couche 58, par exemple avec les portions de la couche 58 s'étendant sur le fond de la cavité 56. Les dimensions de l'élément 78 sont telles que l'élément 62 n'est pas en contact avec le substrat 52 et que l'élément 78 n'est pas en contact avec la couche 54. Autrement dit, les dimensions de l'élément 78 au niveau du plan de la face supérieure du substrat 52 sont inférieures ou égales aux dimensions du fond de la cavité 56. De plus, les dimensions de la couche 58, et plus précisément les dimensions des portions de la couches 58 recouvrant le fond de la cavité 56, sont telles que la partie centrale du fond de la cavité 56 non recouverte par la couche 58 est entièrement constituée de l'élément 78.

Le dispositif comprend en outre une couche 79. La couche 79 entoure latéralement l'élément 78. La couche 79 sépare donc l'élément 78 du substrat 52. L'élément 78 n'est donc pas en contact avec le substrat 52.

Dans le mode de réalisation de la figure 6, la couche 76 est polarisée à la tension de commande des transistors 26 de la figure 3. Ainsi, les doigts 35 de la figure 3, correspondant par exemple à la piste 68 de la figure 6, sont polarisés par l'intermédiaire des éléments conducteurs 78 et 62. Le substrat 52 est par exemple polarisé à la tension de source et la couche 54 est par exemple polarisé à la tension de drain.

A titre de variante, le mode de réalisation de la figure 6 peut ne pas comprendre l'élément 78. La cavité 56 est alors formée de manière à traverser la couche 54 et le substrat 52. La face supérieure de la couche 76 constitue alors le fond de la cavité 56.

Un exemple de procédé de fabrication du dispositif 74 est identique au procédé décrit en relation avec la figure 4, à l'exception de l'étape de formation du substrat 52 qui comprend alors la formation de l'élément 78.

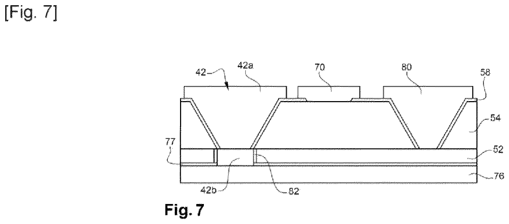

La figure 7 représente plus en détail une autre partie du mode de réalisation du dispositif 74 de la figure 6. Plus précisément, la figure 7 représente un plot 42 d'application de la tension de commande, un plot 80 d'application de la tension de source et un plot 70 d'application de la tension de drain.

Les plots 42, 70 et 80 sont situés sur la même puce, et dans le même dispositif 74 que la structure de la figure 6. Ainsi, la structure de la figure 7 comprend des éléments de la figure 6. La structure de la figure 7 comprend ainsi le substrat 52, la couche 54, la couche 58, la couche 77 et la couche 76. La structure de la figure 7 comprend en outre le réseau d'interconnexion, non représenté. Autrement dit, la structure de la figure 7 comprend l'empilement 60 de couches isolantes, non représentée en figure 7, l'empilement comprenant des pistes conductrices et des vias conducteurs.

Le plot 70 est identique au plot 70 de la figure 5. Ainsi, le plot 70 traverse la couche 58 et est en contact avec la couche 54. Le plot 70 est relié, de préférence connecté, à une source de tension fournissant la tension de drain des transistors 26 des lignes 34 de la figure 3. Le plot 70 est par exemple relié, de préférence connecté, à ladite source de tension par le réseau d'interconnexion non représenté, plus précisément par des pistes conductrices et des vias conducteurs du réseau d'interconnexion non représenté.

Le plot 80 est identique au plot 42 de la figure 5. Ainsi, le plot 80 est situé dans une cavité traversant la couche 54 de manière à atteindre le substrat 52. Le plot 80 est séparé de la couche 54 par la couche isolante 58. Le plot 80 est en contact avec le substrat 52. Le plot 80 diffère du plot 42 de la figure 5 en ce que le plot 80 reçoit la tension de source. Autrement dit, le plot 80 est relié, de préférence connecté, à une source de tension fournissant la tension de source des transistors 26 des lignes 34 de la figure 3. Le plot 80 est par exemple relié, de préférence connecté, à ladite source de tension par le réseau d'interconnexion non représenté, plus précisément par des pistes conductrices et des vias conducteurs du réseau d'interconnexion non représenté.

Le plot 42 de la figure 7 comprend, comme le plot 80 et le plot 42 de la figure 5, une partie conductrice 42a, par exemple en métal, remplissant une cavité traversant la couche 54 et la couche 77 de manière à atteindre le niveau de la face inférieure de la couche 54. Le plot 42 comprend une partie conductrice 42b, par exemple en métal, située dans le substrat 52. La partie 42b est par exemple identique à l'élément 78 de la figure 6. La partie 42b s'étend de la face supérieure du substrat 52 à la face inférieure du substrat 52. La face supérieure de la partie 42b est en contact avec la partie 42a et la face inférieure de la partie 42b est en contact avec la couche 76. La face supérieure de la partie 42b est par exemple en contact avec la couche 58. Les dimensions de la partie 42b sont par exemple telles que la partie 42b n'est pas en contact avec la couche 54, uniquement avec la partie 42a et éventuellement avec la couche 58. Les dimensions de la partie 42b sont par exemple telles que la partie 42a n'est pas en contact avec le substrat 52.

Le plot 42 est relié, de préférence connecté, à une source de tension fournissant la tension de commande des transistors 26 des lignes 34 de la figure 3. Le plot 42 est par exemple relié, de préférence connecté, à ladite source de tension par le réseau d'interconnexion non représenté, plus précisément par des pistes conductrices et des vias conducteurs du réseau d'interconnexion non représenté.

Le dispositif comprend en outre une couche 82. La couche 82 entoure latéralement l'élément 42b. La couche 82 sépare donc l'élément 42b du substrat 52. L'élément 42b n'est donc pas en contact avec le substrat 52.

Les modes de réalisation décrits en relation avec les figures 3 à 7 sont par exemple destinés à être présent dans des circuits de conversion de puissance, par exemple dans des véhicules, par exemple des voitures.

Un avantage des modes de réalisation décrits est que le délai entre l'application de la tension de commande, ou une variation de la tension de commande, et la réception de la tension de commande, ou de la variation de commande, est moins importante.

Un autre avantage des modes de réalisation décrits est qu'un pic de courant de la tension de commande risque moins d'endommager les transistors, le pic étant partagé plus rapidement sur un plus grand nombre de transistors.

Un autre avantage des modes de réalisation décrits est qu'ils n'entraînent pas de modification des transistors.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique (50, 74) comprenant des tranchées (44), les tranchées (44) comprenant chacune un élément conducteur (62, 78) configuré pour relier électriquement les doigts (35) de grilles de transistors (26), situés du côté d'une première face d'une première couche (54), à une deuxième couche (52, 76) s'étendant du côté d'une deuxième face de la première couche (54).

2. Dispositif selon la revendication 1, dans lequel la deuxième couche (52, 76) est configurée pour être polarisée à la tension de commande des transistors (26).

3. Dispositif selon la revendication 1 ou 2, dans lequel les transistors (26) sont agencés en lignes (34), les transistors (26) d'une même ligne (34) étant reliés ensemble par leur grille par un même doigt (35), les lignes (34) étant agencées en colonnes (41), les colonnes (41) étant séparées deux à deux par une tranchée (44), l'élément conducteur (62, 78) de chaque tranchée (44) séparant deux colonnes (41) étant relié à une extrémité de chacun des doigts (35) des deux colonnes.

4. Dispositif selon la revendication 3, dans lequel chaque colonne (41) est située entre deux tranchées (44), chaque doigt (35) étant relié, par une extrémité, à l'élément conducteur (62, 78) d'une des deux tranchées (44), et, par une autre extrémité, à l'élément conducteur (62, 78) de l'autre des deux tranchées (44).

5. Dispositif selon l'une quelconque des revendications 1 à 4, dans lequel la première couche (54) est en GaN, en AlN ou en AlGaN.

6. Dispositif selon l'une quelconque des revendications 1 à 5, dans lequel le dispositif (50, 74) comprend un substrat semiconducteur (52) du côté de la deuxième face de la première couche (54), le substrat (52) constituant la deuxième couche.

7. Dispositif selon la revendication 6, dans lequel chaque tranchée (44) comprend une cavité (56) traversant la première couche (54), le fond de la cavité (56) étant formé par le substrat (52), et l'élément conducteur (62) comprenant une troisième couche conductrice (62) s'étendant sur les parois et le fond de la cavité (56).

8. Dispositif selon l'une quelconque des revendications 1 à 7, dans lequel le dispositif (50, 74) comprend un substrat semiconducteur (52) du côté de la deuxième face de la première couche (54), la face du substrat (52) la plus éloigné de la première couche (54) étant recouverte d'une quatrième couche conductrice (76), la quatrième couche (76) constituant la deuxième couche.

9. Dispositif selon la revendication 8, dans lequel la quatrième couche (76) est en métal.

10. Dispositif selon la revendication 8 ou 9, dans lequel chaque tranchée (44) comprend une cavité (56) traversant la première couche (54), le fond de la cavité (56) étant situé au niveau de la face du substrat (52) la plus proche de la première couche (54), l'élément conducteur (62, 78) comprenant une troisième couche conductrice (62) s'étendant sur les parois et le fond de la cavité et une partie (78) située dans le substrat (52), en contact avec la troisième couche (62) et en contact avec la quatrième couche (76).

11. Dispositif selon la revendication 7 ou 10, dans lequel la troisième couche (62) est séparée de la première couche (54) par une cinquième couche isolante (58).

12. Dispositif selon l'une quelconque des revendications 6 à 11, dans lequel le substrat (52) est en silicium ou en silicium carboné.

13. Dispositif selon l'une quelconque des revendications 1 à 12, dans lequel chaque élément conducteur (62, 78) est relié aux doigts (35) par des pistes et des vias d'un réseau d'interconnexion.

14. Procédé de fabrication d'un dispositif électronique (50, 74) comprenant la formation de tranchées (44), les tranchées (44) comprenant chacune un élément conducteur (62, 78) configuré pour relier électriquement les doigts (35) de grilles de transistors (26), situés du côté d'une première face d'une première couche (54), à une deuxième couche (52, 76) s'étendant du côté d'une deuxième face de la première couche (54).

15. Procédé selon la revendication 14 appliqué à la fabrication d'un dispositif selon l'une quelconque des revendications 1 à 13.
